# EUROPÄISCHE PATENTSCHRIFT

(11) **EP 1 535 323 B1**
(45) Veröffentlichungstag und Bekanntmachung des Hinweises auf die Patenterteilung: **10.01.2007**
(21) Anmeldenummer: 03750316.6
(22) Anmeldetag: 03.09.2003
(51) Int. Cl.: H01L 21/383

(54) **VERFAHREN ZUR BEHANDLUNG EINER PHOTOVOLTAISCH AKTIVEN SCHICHT UND PHOTOVOLTAISCHES ELEMENT AUF ORGANISCHER BASIS**
METHOD FOR TREATING A PHOTOVOLTAIC ACTIVE LAYER AND ORGANIC PHOTOVOLTAIC ELEMENT
PROCEDE DE TRAITEMENT D'UNE COUCHE PHOTOVOLTAIQUEMENT ACTIVE ET ELEMENT PHOTOVOLTAIQUE ORGANIQUE

(30) Priorität: 05.09.2002 DE 10241205
(43) Veröffentlichungstag der Anmeldung: 01.06.2005
(73) Patentinhaber: Konarka Technologies, Inc., Lowell, MA 01852 (US)
(72) Erfinder: BRABEC, Christoph, 4040 Linz (AT); SCHILINSKY, Pavel, 28211 Bremen (DE); WALDAUF, Christoph, 4020 Linz (AT)
(74) Vertreter: Altenburg, Udo
(86) Internationale Anmeldenummer: PCT/DE2003/002929
(87) Internationale Veröffentlichungsnummer: WO 2004/025746

(56) Entgegenhaltungen:
- DATABASE CHEMABS [Online] CHEMICAL ABSTRACTS SERVICE, COLUMBUS, OHIO, US; 24. Juni 2002 (2002-06-24), CAMAIONI, NADIA ET AL: "Solar cells based on poly(3-alkyl) thiophenes and [60]fullerene: a comparative study" XP002286364 gefunden im STN Database accession no. 2002:470013 & JOURNAL OF MATERIALS CHEMISTRY , 12(7), 2065-2070 CODEN: JMACEP; ISSN: 0959-9428, 21. Juni 2002 (2002-06-21),
- HUYNH, WENDY ET AL: "Efficient nanorod and polymer photovoltaics from thermal treatment" PROCEEDINGS - ELECTROCHEMICAL SOCIETY , 2001-10(PHOTOVOLTAICS FOR THE 21ST CENTURY II), 195-198 CODEN: PESODO; ISSN: 0161-6374, 2001, XP001182311 10-2001
- ARIAS, A. C. ET AL: "Vertically segregated polymer-blend photovoltaic thin-film structures through surface-mediated solution processing" APPLIED PHYSICS LETTERS , 80(10), 1695-1697 CODEN: APPLAB; ISSN: 0003-6951, 11. März 2002 (2002-03-11), XP001104270

## Beschreibung

Verfahren zur Behandlung einer photovoltaisch aktiven Schicht und photovoltaisches Element auf organischer Basis

Die Erfindung betrifft ein photovoltaisches Element auf organischer Basis, insbesondere eine Solarzelle mit einer im blauen Bereich absorbierenden photovoltaisch aktiven Schicht.

Bekannt sind Solarzellen auf organischer Basis aus der US 5,331,183 von 1994 und durch zahlreiche Veröffentlichungen seitdem.

Insbesondere sind auch organische Solarzellen auf Polyalkylthiophenbasis (P3AT) bekannt. Ein typischer Zellaufbau dieses photovoltaischen Elements umfasst folgende Schichten: Eine Anode, beispielsweise aus ITO (Indium tin Oxide) darauf eine Lochleitschicht aus einem Copolymer wie einem Gemisch aus PEDOT mit PSS als Anion. Darauf liegt eine Schicht aus P3AT:PCBM, (Poly-3-hexylthiophen im Gemisch mit PhenylC₆₁-ButoxyMethoxy) die die photovoltaisch aktive Schicht ist. Auf dieser befindet sich dann noch die Kathodenschicht, beispielsweise aus einem Metall wie Aluminium oder einer Ca/Ag-Legierung. Die einzelnen Schichten können jedoch abweichen, insbesondere können sowohl die Elektroden als auch der Akzeptor (PCBM) aus anderem Material sein. Beispielsweise wurden Cyano substituierte PPVs (CN-PPVs) schon als Akzeptor verwendet, es sind jedoch beliebig viele Zusätze zu dem Polythiophen denkbar.

Es besteht der Bedarf, die Absorptionsmaxima der photovoltaisch aktiven Schicht in Längerwellige zu verschieben, weil unter anderem auch das Vermischen des Polythiophens mit dem Fulleren zu einer Blauverschiebung des Absorptionsmaximums führt. Dadurch wird der Mismatch, also die Diskrepanz des Absorptionsmaximums zu der Hauptemission des Sonnenlichts größer.

Aufgabe der Erfindung ist es, ein alternatives Verfahren anzugeben, durch das das Absorptionsmaximum einer photovoltaisch aktiven Schicht in den längerwelligen Bereich verschoben und/oder eine Verbesserung der Effizienz (z. B. durch Erhöhung des Kurzschluss-Stroms) erreicht werden kann. Insbesondere ist es Aufgabe der vorliegenden Erfindung ein Verfahren anzugeben, durch das das Absorptionsmaximum einer, ein Poly(alkyl)thiophen im Gemisch mit einem Fulleren enthaltenden, photovoltaisch aktiven Schicht ins Längerwellige verschoben werden kann. Im Stand der Technik J. Mater. Chem, 2002, 12, 2065-2070 wird die Rotverschiebung am System PHT-3 durch Tempern beschrieben.

Gegenstand der Erfindung ist ein Verfahren zur Behandlung einer photovoltaisch aktiven Schicht mit einem Lösungsmittel, dadurch gekennzeichnet, dass die photovoltaisch aktive Schicht mit Lösungsmittelmolekülen in Berührung kommt. Außerdem ist Gegenstand der Erfindung ein photovoltaisches Element mit einer photovoltaisch aktiven Schicht, die ein Polyalkylthiophen im Gemisch mit einem Additiv enthält, wobei die photovoltaisch aktive Schicht ein Absorptionsmaximum im tiefroten Bereich hat.

Die photovoltaisch aktive Schicht ist bevorzugt ein Polyalkylthiophen, das im Gemisch mit einem Additiv wie einem Fulleren, insbesondere einem Methanofulleren vorliegt. Weitere möglich Additive anstatt des Fullerenes wären z. B. inorganische Nanoteilchen auf Basis CdTe (Cadmium-Tellur), CdS (Cadmium-Sulfid), Polymere mit einer hohen Elektronenaffinität wie z. B. Cyano- substituierte PPVs (CN-PPVs) oder kleine Moleküle mit einer hohen Elektronenaffinität, wie z. B Tetra-Cyano-Quinon (TCNQ) oder Tetra Cyano-Anthracen-Quinon (TCAQ).

Nach einer Ausführungsform der Erfindung wird die photovoltaisch aktive Schicht einem Lösungsmitteldampf bei Raumtemperatur ausgesetzt. Dies kann beispielsweise dadurch erfolgen, dass die photovoltaisch aktive Schicht über ein(em) Gefäß mit Lösungsmittel geführt (gehalten) wird und/oder dass Lösungsmitteldampf über die photovoltaisch aktive Schicht geleitet wird.

Nach einer Ausführungsform wird die photovoltaisch aktive Schicht dem Lösungsmitteldampf nur sehr kurz, das heißt weniger als eine Minute oder beispielsweise nur im Sekunden oder Millisekundenbereich ausgesetzt.

Nach einer Ausführungsform der Erfindung wird die photovoltaisch aktive Schicht bei einer Temperatur von zumindest 70°C bevorzugt ca. 80°C oder höher getempert gleichzeitig mit der Temperung erfolgt auch die Behandlung mit Lösungsmittel. Der Fortschritt der Temperung kann durch die Erhöhung des Kurzschluss-Stromes mitverfolgt werden. Andere Kombinationen aus Temperatur und Zeit sind vorstellbar, der Prozess gilt als abgeschlossen sobald sich die photovoltaischen Parameter nicht mehr weiter verbessern. Die Temperung kann durch Einbringen der photovoltaisch aktiven Schicht in einen Trockenofen oder auf eine Hotplate oder ähnliches erfolgen.

Als Lösungsmittel können beispielsweise aromatische Lösungsmittel wie Xylol, Toluol, oder ähnliches eingesetzt werden oder halogenhaltige Lösungsmittel wie Chloroform oder ähnliches. Die Wahl des geeigneten Lösungsmittel hängt vom Gemisch des die photovoltaisch aktive Schicht bildenden Materials ab. Die Wirkung des Lösungsmittels besteht beispielsweise darin, dass das Lösungsmittel Xylol, Toluol, Butanon und/oder Chloroform und/oder ein weiteres Lösungsmittel oder ein beliebiges Gemisch dieser Lösungsmittel das Poly-alkyl-Thiophen zumindest teilweise anlöst und/oder weich macht.

Die Herstellung der photovoltaisch aktiven Schicht erfolgt in herkömmlicher Weise, nach dem Stand der Technik wird beispielsweise aus einer P3AT (Poly-3-alkyl-Thiophen) /PCBM (PhenylC₆₁Butoxymethoxy) Lösung ein lackgeschleuderter Film gebildet oder durch gängige Druckverfahren (Siebdruck, Flexodruck...) appliziert.

Im folgenden wird die Figur noch anhand dreier Graphiken, die Versuchsergebnisse wiedergeben, näher erläutert:

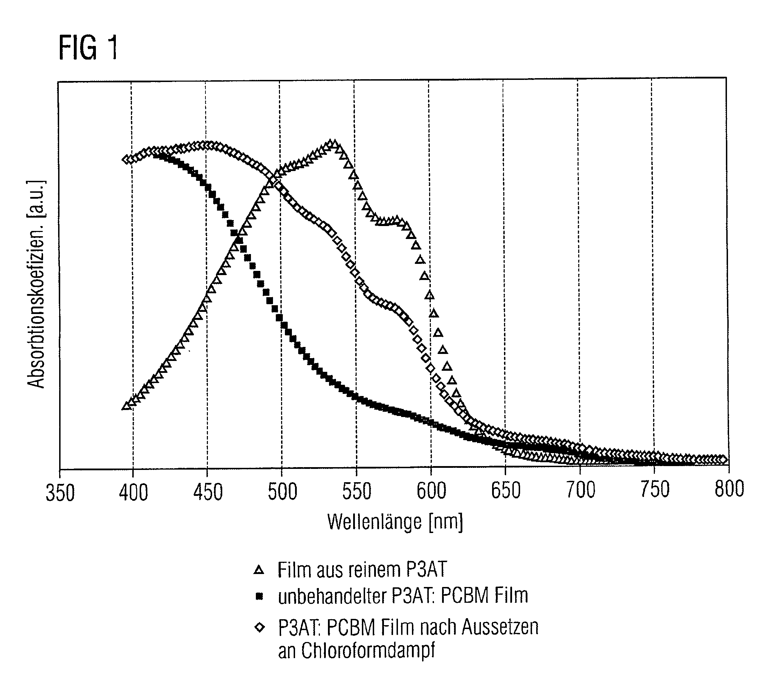

Figur 1 zeigt die Beobachtung der Auswirkung von Lösungsmitteldämpfen auf die Absorption von aus Chloroform lackgeschleuderten P3AT Filmen mit und ohne Fullerene auf Glas: Die Dreiecke zeigen einen reinen P3AT Film auf Glas, die vollen Quadrate einen P3AT/PCBM Film. Es ist deutlich zu beobachten, dass diesem Film der für das P3AT typische Absorptionsbeitrag im Wellenlängenbereich um 550 nm fehlt. Nachdem der Film Chloroformdampf ausgesetzt wurde (offene Rauten), ändert sich sein Absorptionsverhalten und die für das P3AT typischen Absorptionscharakteristika sind wieder zu beobachten.

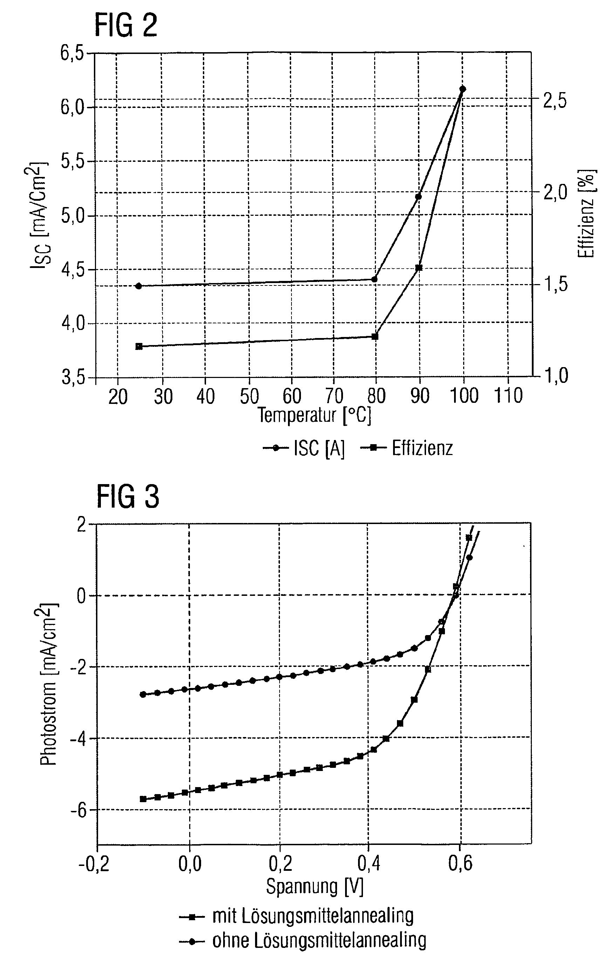

Figur 2: Änderung des Kurzschluss-Stromes Isc (volle Quadrate) und der Effizienz (volle Kreise) mit der Temperatur, bei der die Schicht getempert wurde. Die Probe (Aufbau: ITO/PEDOT/P3HT:PCBM/Ca/Ag) wurde jeweils 20 Minuten getempert, die elektrischen Charakteristika (Isc und Effizienz) wurden jeweils bei Raumtemperatur unter Beleuchtung mit 70 mW/cm² Weißlicht von einer Xenonlampe gemessen. Man kann erkennen, dass ab einer Temperatur von > 80 ° C der Kurzschluss-Strom und dadurch auch die Effizienz zu steigen beginnt.
Figur 3: Strom/Spannungs (I/V) - Kennlinie von temperaturbehandelten Zellen, einmal vor (volle Kreise) und nach (volle Quadrate) der Behandlung mit Lösungsmitteldampf. Die Erhöhung des Kurschluss-Stroms (Isc) und der Effizienz spiegelt die Rotverschiebung des Absorptionsverhaltens (wie in Figur 1 dargestellt) der Zelle wieder.

Durch das Vermischen von P3ATs, im speziellen von Polyhexylthiophene mit Fullerenen wird das Absorptionsmaximum des P3ATs um mehr als 100 nm in den blauen Spektralbereich verschoben. Dadurch wird der spektrale Mismatch der Solarzelle zum Sonnenspektrum größer. Die Erfindung löst folgende Probleme:
Rückverschiebung der Absorption des P3AT/Fullerene Films in den roten Spektralbereich durch Lösungsmittelannealing und
Erhöhung der Effizienz der Solarzelle durch zusätzliches Temperatur-annealing.

Als "Annealing" wird die Behandlung einer photovoltaisch aktiven Schicht im Rahmen dieser Erfindung zur Lösung der Aufgabe, also zur Rotverschiebung des Absorptionsmaximums der Schicht, bezeichnet.

## Patentansprüche

1. Verfahren zur Behandlung einer photovoltaisch aktiven Schicht mit einem Lösungsmittel **dadurch gekennzeichnet, dass** die photovoltaisch aktive Schicht mit Lösungsmittelmolekülen in Berührung kommt.

2. Verfahren nach Anspruch 1, bei dem die photovoltaisch aktive Schicht ein Polyalkylthiophen ist, das im Gemisch mit einem Additiv wie einem Fulleren, insbesondere einem Methanofulleren vorliegt.

3. Verfahren nach einem der Ansprüche 1 oder 2, bei dem die photovoltaisch aktive Schicht einem Lösungsmitteldampf ausgesetzt wird.

4. Verfahren nach Anspruch 3, bei dem die photovoltaisch aktive Schicht dem Lösungsmitteldampf bei Raumtemperatur ausgesetzt wird.

5. Verfahren nach Anspruch 3 oder 4, bei dem die photovoltaisch aktive Schicht dem Lösungsmitteldampf nicht länger als eine Minute ausgesetzt wird.

6. Verfahren nach einem der vorstehenden Ansprüche, bei dem das Lösungsmittel Xylol, Toluol, Butanon und/oder Chloroform und/oder ein weiteres Lösungsmittel und/oder ein beliebiges Gemisch dieser Lösungsmittel ist und das Lösungsmittel das Poly-alkyl Thiophen zumindest teilweise anlöst oder weich macht.

7. Verfahren nach einem der vorstehenden Ansprüche, bei dem die photovoltaisch aktive Schicht bei einer Temperatur von zumindest 70 °c getempert wird.

8. Photovoltaisches Element mit einer photovoltaisch aktiven Schicht, die ein Polyalkylthiophen im Gemisch mit einem Additiv enthält. wobei die photovoltaisch aktive Schicht ein Absorptionsmaximum im tiefroten Bereich hat.

9. Element nach Anspruch 8, bei dem das Additiv ein Fulleren, ein Polymer mit einer hohen Elektronen affinität, ein Material aus anorganischen Nanoteilchen oder ein Material aus kleinen Molekülen mit einer hohen Elektronen affinität ist.

10. Element nach Anspruch 9, bei dem das Fulleren PCBM ist.

11. Element nach Anspruch 9, bei dem das Polymer ein Cyano-substituiertes PPV (CN-PPV) ist.

12. Element nach Anspruch 9, bei dem das Material aus anorganischen Nanopartikeln CdTe oder CdS enthält.

13. Element nach Anspruch 9, bei dem das Material aus kleinen Molekülen TCNQ oder TCAQ ist.

## Claims

1. Method of treating a photovoltaically active layer with a solvent, **characterised in that** the photovoltaically active layer comes into contact with solvent molecules.

2. Method according to claim 1, wherein the photovoltaically active layer is a polyalkylthiophene, which is present in the mixture with an additive such as a fullerene, in particular a methanofullerene.

3. Method according to either of claims 1 or 2, wherein the photovoltaically active layer is exposed to a solvent vapour.

4. Method according to claim 3, wherein the photovoltaically active layer is exposed to the solvent vapour at room temperature.

5. Method according to claim 3 or 4, wherein the photovoltaically active layer is exposed to the solvent vapour for no longer than one minute.

6. Method according to one of the preceding claims, wherein the solvent is xylene, toluene, butanone and/or chloroform and/or a further solvent and/or any mixture of these solvents and the solvent at least partly starts to dissolve or soften the polyalkylthiophene.

7. Method according to one of the preceding claims, wherein the photovoltaically active layer is tempered at a temperature of at least 70°C.

8. Photovoltaic element having a photovoltaically active layer, which contains a polyalkylthiophene in a mixture with an additive, wherein the photovoltaically active layer has an absorption maximum in the deep red range.

9. Element according to claim 8, wherein the additive is a fullerene, a polymer with a high electron affinity, a material composed of inorganic nanoparticles or a material composed of small molecules.

10. Element according to claim 9, wherein the fullerene is PCBM.

11. Element according to claim 9, wherein the polymer is a cyano-substituted PPV (CN-PPV).

12. Element according to claim 9, wherein the material composed of inorganic nanoparticles contains CdTe or CdS.

13. Element according to claim 9, wherein the material composed of small molecules is TCNQ or TCAQ.

## Revendications

1. Procédé pour le traitement d'une couche à activité photovoltaïque à l'aide d'un solvant, **caractérisé en ce que** la couche à activité photovoltaïque entre en contact avec des molécules d'un solvant.

2. Procédé selon la revendication 1, dans lequel la couche à activité photovoltaïque est un polyalkylthiophène, qui se présente en mélange avec un additif tel qu'un fullerène, en particulier un méthanofullerène.

3. Procédé selon l'une des revendications 1 ou 2, dans lequel la couche à activité photovoltaïque est exposée à une vapeur de solvant.

4. Procédé selon la revendication 3, dans lequel la couche à activité photovoltaïque est exposée à la vapeur de solvant à la température ambiante.

5. Procédé selon la revendication 3 ou 4, dans lequel la couche à activité photovoltaïque est exposée à la vapeur de solvant pendant un temps non supérieur à une minute.

6. Procédé selon l'une des revendications précédentes, dans lequel le solvant est le xylène, le toluène, la butanone et/ou le chloroforme, et/ou représente un solvant supplémentaire et/ou un mélange quelconque de ces solvants, et le solvant va au moins partiellement dissoudre ou plastifier un polyalkylthiophène.

7. Procédé selon l'une des revendications précédentes, dans lequel la couche à activité photovoltaïque est ajustée à une température d'au moins 70°C.

8. Elément photovoltaïque comportant une couche à activité photovoltaïque, qui contient un polyalkylthiophène en mélange avec un additif, la couche à activité photovoltaïque possédant un maximum d'absorption dans le rouge profond.

9. Elément selon la revendication 8, dans lequel l'additif est un fullerène, un polymère ayant une grande activité électronique, un matériau constitué de nanoparticules inorganiques, ou un matériau constitué de petites molécules ayant une grande affinité électronique.

10. Elément selon la revendication 9, dans lequel le fullerène est le PCBM.

11. Elément selon la revendication 9, dans lequel le polymère est un PPV cyano-substitué (CN-PPV).

12. Elément selon la revendication 9, dans lequel le matériau constitué de nanoparticules inorganiques contient du CdTe ou du CdS. ,

13. Elément selon la revendication 9, dans lequel le matériau constitué de petites molécules est le TCNQ ou le TCAQ.
